# EUROPEAN PATENT APPLICATION

(11) **EP 2 058 849 A2**
(43) Date of publication of application: **13.05.2009**
(21) Application number: 08168783.2
(22) Date of filing: 10.11.2008
(51) Int. Cl.: H01L 21/67

(54) **Rotating temperature controlled substrate pedestal for film uniformity**

(30) Priority: 29.04.2008 US 111817; 08.11.2007 US 986329 P
(71) Applicant: Applied Materials, Inc., Santa Clara, CA 95054 (US)
(72) Inventor: Lubomirsky, Dimitry, Cupertino, CA 95014 (US); Floyd, Kirby H., San Jose, CA 95119 (US)
(74) Representative: Zimmermann & Partner

(57) **Abstract**

Substrate processing systems are described. The systems may include a processing chamber (708a-f), and a substrate support assembly (340; 350) at least partially disposed within the chamber. The substrate support assembly is rotatable by a motor (418; 518) yet still allows electricity, cooling fluids, gases and vacuum to be transferred from a non-rotating source outside the processing chamber to the rotatable substrate support assembly inside the processing chamber. Cooling fluids and electrical connections can be used to raise or lower the temperature of a substrate supported by the substrate support assembly. Electrical connections can also be used to electrostatically chuck the wafer to the support assembly. A rotary seal or seals (which may be low friction O-rings) are used to maintain a process pressure while still allowing substrate assembly rotation. Vacuum pumps can be connected to ports which are used to chuck the wafer. The pumps can also be used to differentially pump the region between a pair of rotary seals when two or more rotary seals are present.

## Description

This application claims the benefit of U.S. Provisional Application NO. 60/986,329, filed November 8, 2007. This application is related to U.S. Application No. 11/754,924, filed May 29, 2007, having Attorney Docket No. A10495/T68810, U.S. Application No. 11/754,916, filed May 29, 2007, and having Attorney Docket No. A11100/T72410, and U.S. Application No. 11/754,858, filed May 29, 2007, having Attorney Docket No. A11162/T72710. All three of the above applications claim the benefit of U.S. Provisional Application No. 60/803,499, filed May 30, 2006. The entire content of all these applications are herein incorporated by reference for all purposes.

### FIELD

This application relates to manufacturing technology solutions involving equipment, processes, and materials used in the deposition, patterning, and treatment of thin-films and coatings, with representative examples including (but not limited to) applications involving: semiconductor and dielectric materials and devices, silicon-based wafers and flat panel displays (such as TFTs). In particular, this application relates to a semiconductor processing system.

### BACKGROUND

A conventional semiconductor processing system contains one or more processing chambers and a means for moving a substrate between them. A substrate may be transferred between chambers by a robotic arm which can extend to pick up the substrate, retract and then extend again to position the substrate in a different destination chamber. Each chamber has a pedestal or some equivalent way of supporting the substrate for processing.

A pedestal can be a heater plate in a processing chamber configured to heat the substrate. The substrate may be held by a mechanical, pressure differential or electrostatic means to the pedestal between when a robot arm drops off the substrate and when an arm returns to pick up the substrate. Lift pins are often used to elevate the wafer during robot operations.

One or more semiconductor fabrication process steps are performed in the chamber, such as annealing the substrate or depositing or etching films on the substrate. Process uniformity across a substrate is always a consideration and has become especially challenging in certain processes. The following example will help illustrate the deficiency. Dielectric films must be deposited into complex topologies during some processing steps. Many techniques have been developed to deposit dielectrics into narrow gaps including variations of chemical vapor deposition techniques which sometimes employ plasma techniques.

High-density plasma (HDP)-CVD has been used to fill many geometries due to the perpendicular impingement trajectories of the incoming reactants and the simultaneous sputtering activity. Some very narrow gaps, however, have continued to develop voids due, in part, to the lack of mobility following initial impact. Reflowing the material after deposition can fill the void but, if the dielectric is predominantly, e.g. SiO₂, it also may consume a non-negligible portion of a wafers' thermal budget.

By way of its high surface mobility, flow-able materials such as spin-on glass (SOG) have been useful in filling some of the gaps which were incompletely filled by HDP-CVD. SOG is applied as a liquid and baked after application to remove solvents, thereby converting material to a solid glass film. The gap-filling and planarization capabilities are enhanced for SOG when the viscosity is low, however, this is also the regime in which film shrinkage during cure is high. Significant film shrinkage results in high film stress and delamination issues, especially for thick films.

For some chemistries, separating the delivery paths of the oxidizing precursors and the organo-silane precursors enables the creation of flow-able films during a process on a substrate surface. Since the films are grown rather than poured onto the surface, the organic components needed to decrease viscosity are allowed to evaporate during the process which reduces the shrinkage affiliated with the now-optional bake step. The downside of the separation is that the deposited film will only flow freely on the surface of the substrate for a period of time. The organic content of the precursors must be controlled so that, during this time, vias and other high-aspect ratio geometries are filled without yield-limiting voids. If the viscosity of the growing film rises too rapidly, the film uniformity may also be impacted.

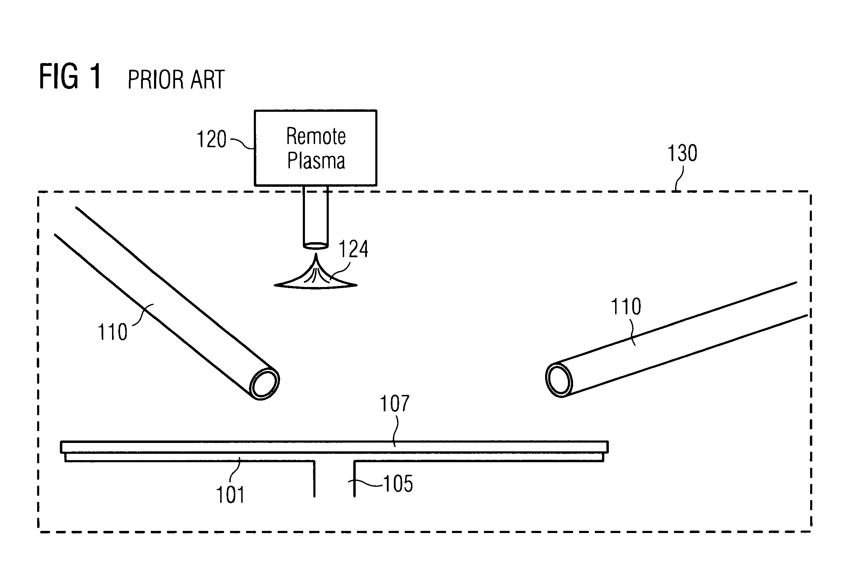

FIG. 1 shows a very simple embodiment of a separation between oxidizing and organo-silane precursors. The figure shows several elements present during processing. The oxidizing precursor (e.g. oxygen (O₂), ozone (O₃), ...) may be excited by a plasma **120** "remote" in the sense that it does not directly excite gases arriving from other paths (shown here as two pipes 110). The pipes of FIG. 1 may carry the organo-silane precursor (e.g. TEOS, OMCTS, ... ), preventing chemical reaction between the two classes of precursors until they are at least inside the processing region **130** and possibly near or on the substrate surface **107.** The substrate is shown supported by a pedestal assembly **101,105.**

Note that the path of the oxygen from the vertical tube can be interrupted by a baffle 124 whose purpose is to discourage inhomogeneous reaction above the substrate surface which obviously can impact the uniformity of properties and thicknesses of the deposited film. Attempts have been made to adjust the placement and number of the tubes **110** as well as more significant alterations to the delivery hardware without complete success.

The motivating example just presented is by no means the only substrate processing technique which suffers from a lack of uniformity. Even within the art of dielectric deposition, gas supply methods in conventional PECVD and HDP-CVD processes result in a lack of deposition uniformity. In a variety of substrate processing steps, there remains a need in the art to further improve uniformity.

### BRIEF SUMMARY

In light of the above, a semiconductor processing system according to independent claim 1 is provided.
In one embodiment, a semiconductor processing system is provided, comprising a processing chamber having an interior capable of holding an internal chamber pressure which can be different from the external chamber pressure; a pumping system coupled to said chamber and adapted to remove material from the processing chamber; a substrate support assembly comprising: a substrate support member adapted to support a substrate inside the processing chamber; a substrate support shaft coupled to the substrate support member in a rotationally rigid manner, wherein the substrate support shaft can rotate relative to the processing chamber; a motor coupled to the substrate support shaft and configured to rotate the substrate support assembly at a rotational speed between 1 RPM and 2000 RPM; at least one rotary seal coupled between the substrate support shaft and the processing chamber, wherein the rotary seal allows the system to maintain an internal chamber pressure different from the external chamber pressure even when the substrate support assembly is rotating; at least one rotary fluid coupling configured to conduct a fluid between at least one stationary channel and at least one rotatable channel within the processing chamber; and a rotary electrical feed-through configured to allow electricity to pass between at least one stationary conductor outside the processing chamber and at least one rotatable conductor within the processing chamber.

Disclosed embodiments include substrate processing systems that have a processing chamber and a substrate support assembly at least partially disposed within the chamber. The substrate support assembly is rotatable by a motor. Despite such rotation, in embodiments the system still allows electricity, cooling fluids, gases and vacuum to be transferred between a non-rotating source outside the processing chamber and the rotatable substrate support assembly inside the processing chamber. In the case of electricity, a rotating conductor is electrically coupled to a stationary conductor. For fluids (including gases, liquids and vacuum), a rotating channel is fluidly coupled to a stationary channel. Cooling fluids and electrical connections can be used to change the temperature of a substrate supported by the substrate support assembly. Electrical connections can also be used to electrostatically chuck the wafer to the support assembly. One or more rotary seals (which may be low friction O-rings) are used to maintain vacuum while still allowing substrate assembly rotation. Vacuum pumps can be connected to ports which are used to chuck the wafer or other ports which are used to differentially pump the rotary seals.

In some of the embodiments one or more heating elements are positioned in or around the substrate support member. In some of the embodiments a cooling element is located in or around the substrate support member to reduce the temperature of the support member and the substrate. The cooling element may also be configured to cool the rotary seals to extend their lifespan.

The support assembly may further include a lift mechanism coupled to the shaft for raising and lowering the substrate support member.

Disclosed embodiments may still further include semiconductor processing systems having an eccentric rotation substrate support assembly at least partially disposed within a film deposition chamber. The substrate support assembly may include a substrate support member, a shaft coupled to the substrate support member, and a motor coupled to the shaft to rotate the substrate support member. The shaft may be positioned off center from the substrate support member to create an eccentric rotation of the support member relative to the rotation of the shaft.

Additional disclosed embodiments include semiconductor processing systems having a tilt-able substrate support assembly at least partially disposed within a film deposition chamber. The substrate support assembly may include a substrate support member, a shaft coupled to the substrate support member, and a motor coupled to the shaft to rotate the substrate support member. The substrate support member may support a substrate which is tilted with respect to the shaft to create a wobble when the substrate support is rotated.

More embodiments and features are set forth in part in the description that follows, and in part will become apparent to those skilled in the art upon examination of the specification or may be learned by the practice of the disclosed embodiments. The features and advantages of the disclosed embodiments may be realized and attained by means of the instrumentalities, combinations, and methods described in the specification. Further advantages, features, aspects and details are evident from the dependent claims, the description and the drawings.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

A further understanding of the nature and advantages of the disclosed embodiments may be realized by reference to the remaining portions of the specification and the drawings wherein like reference numerals are used throughout the several drawings to refer to similar components. In some instances, a sublabel is associated with a reference numeral and follows a hyphen to denote one of multiple similar components. When reference is made to a reference numeral without specification to an existing sublabel, it is intended to refer to all such multiple similar components.

FIG. 1 shows a schematic of a prior art processing region within a deposition chamber and a remote plasma region for growing films with separate oxidizing and organo-silane precursors;

FIG. 2 shows a side view of a substrate support assembly according to disclosed embodiments;

FIG. 3 shows a cross-section of a substrate support shaft (part of the substrate support assembly) inside a shaft housing;

FIG. 4 shows a substrate support assembly with temperature controlled fluid flowing through rotary fluid coupling, the shaft and substrate support member according to disclosed embodiments.

FIG. 5 shows a substrate support assembly with cooling fluid flowing through rotary fluid couplings and cooling the rotary seal region of a substrate support shaft according to disclosed embodiments.

FIG. 6 shows a 49-point measurement map without and with a 10 RPM substrate rotation according to disclosed embodiments during deposition of an oxide film.

FIG. 7 shows a substrate processing system according to disclosed embodiments.

FIG. 8 shows a substrate processing chamber according to disclosed embodiments.

### DETAILED DESCRIPTION

Implementations of disclosed embodiments include a substrate support assembly modified to allow substrate rotation during processing inside a processing chamber. The rotation is desirable in virtually all substrate processing steps because it enables a more uniform process. In the case of a deposition process, substrate rotation can improve the thickness uniformity of the deposited film. When reactants involved in the deposition process have low or transient surface mobility, rotating a wafer will especially help to create a more uniform film. As a result, disclosed embodiments will help to reduce substrate reflow steps and deposition temperatures, thereby allowing the thermal budget to be spent elsewhere. Disclosed embodiments are appropriate for the deposition of all materials (e.g. metal, semiconducting and insulating layers).

Providing the ability to rotate a substrate inside a processing chamber with a motor located outside the chamber requires the incorporation of rotary seals. Rotary seal assemblies using one or preferably more O-rings may be specially designed or obtained commercially and are made out of a variety of materials. A pressure must be applied against the O-ring seals to allow the process chamber to maintain an internal pressure significantly different than the external pressure. A mechanical force is supplied to compress the O-ring and the elasticity of the O-ring ensures that a seal is made. The mechanical force can be provided by gravity, an adjustable fastening mechanism (e.g. bolts), or by a variety of other substantially equivalent means. Compressible seals which are not typically referred to as O-rings can also be used.

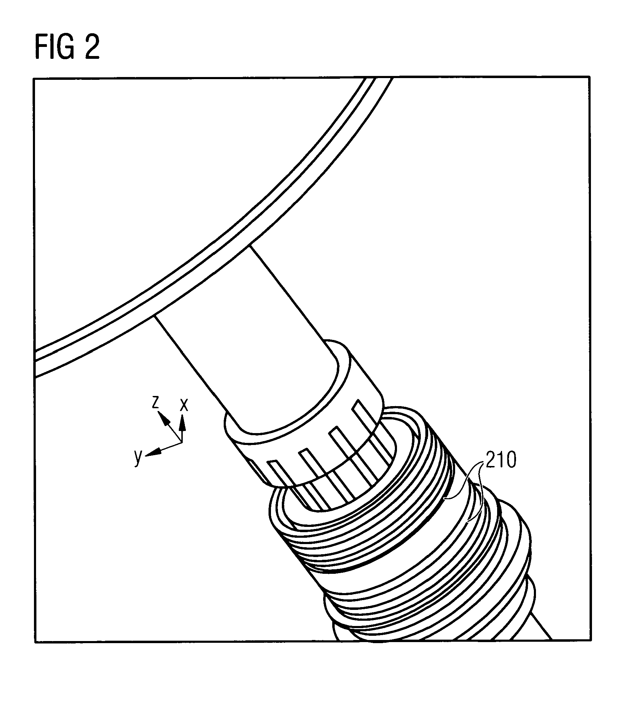

One other method involves designing one or more O-ring grooves into one of two concentric cylindrical pieces, and ensuring that the inner and outer diameters are chosen so the manufacturer recommended pressure is applied to compress the O-rings. FIG. 2 shows one such cylindrical piece. Several perfluoroelastomer O-rings (from Performance Sealing Inc.) are shown **210** confined in grooves on a rotating substrate support shaft. It is important to choose sealing products which are recommended for rotary applications. Such O-rings may have Teflon^{®} jackets, Teflon^{®} coatings, embedded lubricants or some other way to mitigate friction (alternatives include Ferrofluidic^{®} seals from Ferrotec). During the assembly process an outer cylinder is placed over the confined O-rings to make a process seal in this embodiment. In another embodiment, the O-rings could be confined in the outer cylinder (not shown).

In FIG. 2, the rotary seal is an O-ring which rotates with the substrate support pedestal. In some embodiments, the substrate support assembly shown can move back and forth (e.g. up and down) along the axis of the substrate support shaft. This may be a helpful parameter in some processes and robot manipulations. It should also be noted that the rotary seal could be located on the stationary mating piece (not shown). Though the O-ring is stationary in such a configuration, it would still be called a rotary seal.

Again referring to the picture in FIG. 2, two adjacent O-rings are labeled **210.** The region above the top one is adjacent to or part of the interior of the processing chamber while the region below the bottom O-ring may be at atmospheric pressure. Regardless of whether the pressure inside the chamber is different or the same as the pressure outside the chamber, it is beneficial to apply vacuum to the region between two adjacent O-rings to lower the chance of contaminants from entering the process chamber. Therefore, a pumping port can be attached between the two O-ring seals to evacuate the region. This technique is called differential pumping and can help protect the processing region from air leaking in from outside the chamber under optimal conditions or if there is a problem with the first O-ring seal. Differential pumping may be done at more than one location (e.g. between each pair of a trio of O-rings). This becomes particularly desirable if the process benefits from especially low leakage rates (such chambers will usually have low base pressures, e.g. <10⁻⁵ Torr) as with some physical vapor deposition (PVD) processes. Here and throughout, the term vacuum is used to describe a variety of evacuated regions. A vacuum is obviously not devoid of all gases or fluids, but a vacuum can be maintained at pressures below one atmosphere (760 Torr) to provide a variety of benefits.

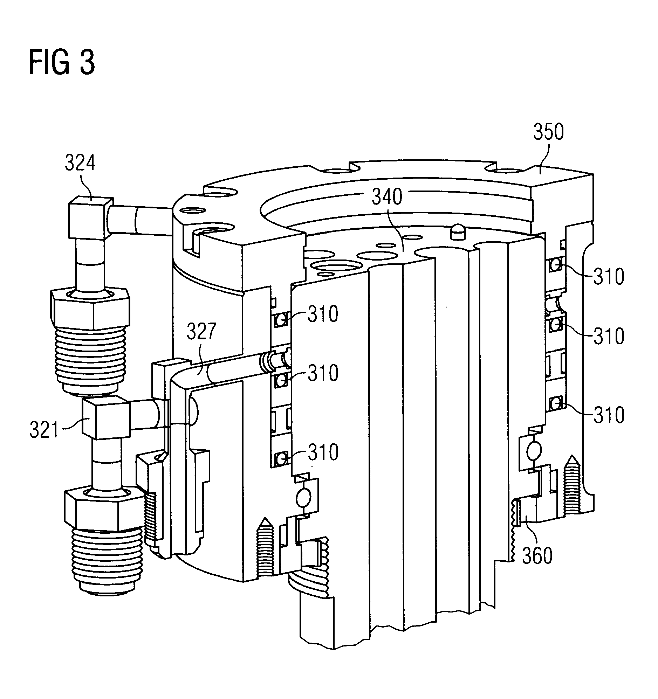

An assembled embodiment is shown in FIG. 3 and shows compressed O-rings **310** sealed between the rotatable substrate support shaft **340** and the stationary rotary seal housing **350.** Three vacuum connections are depicted in FIG. 3, two of which **321,324** are for voiding regions of air or gases which may otherwise enter the processing chamber. Vacuum connection **324** is for evacuating the seal between the top flange of the stationary rotary seal housing of any leakage or trapped volume of air. Vacuum connection 321 is the differential pumping port described earlier in association with FIG. 2 which provides a second line of defense against air entering the processing region from below **360.** Some alternate constructions may benefit from the use of these ports as purge ports where an inert gas (like N2) is flowed through a region (e.g. **324**) in order to displace reactive species.

The remaining vacuum connection **327** in FIG. 3 is present in some embodiments and provides vacuum around the perimeter of the rotatable substrate support shaft **340** which then passes through an aperture in the shaft (essentially regardless of rotational position) allowing the vacuum to be used to "chuck" or hold a substrate to the pedestal even during rotation. This type of connection is referred to as a rotary fluid union or rotary fluid coupling and can be used for vacuum, as indicated, but also to conduct a flow of gas or liquid. For the vacuum application of FIG. 3, substrate chucking occurs if the pressure in the processing chamber is higher than the pressure which the vacuum pump creates near the pedestal. While vacuum chucking is not very useful in low pressure processes like PVD, many processes employing process pressures of 0.5 Torr or above (e.g. Alectrona) *can* use this method of holding a substrate. All three vacuum connections are shown with 90° fittings and compression fitting connections but alternate methods of construction are possible.

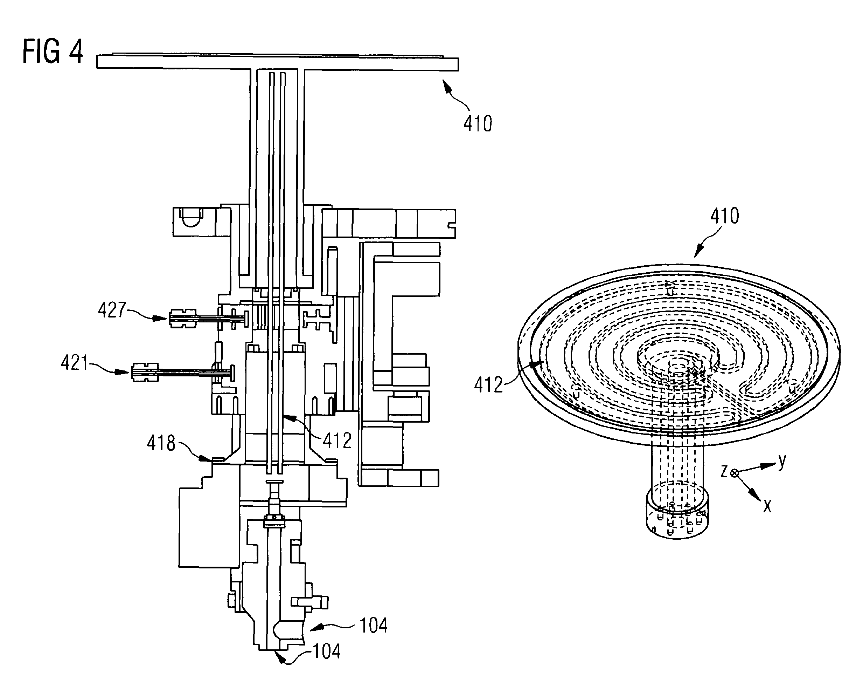

A more complete substrate support assembly is shown in FIG. 4 and represents an disclosed embodiment. The differential pumping port **421** and vacuum chucking port **427** are labeled again to provide perspective. In this embodiment additional ports and components are added to allow adjustment of the substrate temperature. To enable such adjustment, this embodiment includes a rotary fluid union commercially available (from e.g. Deublin Company) and equipped with stationary fluid connections **404.** The cooling fluid flows up through the rotary union, through the substrate support shaft and member (or pedestal in this embodiment) **412** before returning through the alternate channel and exiting through the rotary union **408.** The typical application in substrate processing will be to reduce the temperature of the substrate but the "cooling fluid" may be used to warm the pedestal as well. The standard definition of the term fluid is being used throughout this document; fluids can be liquids, gases or combinations thereof. Therefore, for example, a rotary fluid coupling can be used to couple a cooling fluid, but also a gas or vacuum.

The cooling fluid can be a wide variety of fluids and in embodiments may be water alone or in combination with, for example, ethylene glycol. It is desirable that the interior walls of the cooling fluid channel are compatible with whatever cooling fluid is used to maximize the useful life of the apparatus. The substrate temperature can be held at a requested temperature between 5°C and 120°C or between 20°C and 60°C in different embodiments. The cooling fluid temperature is controlled by a recirculating chiller (from e.g. Thermo Scientific). Though the recirculated fluid will generally be chilled in the recirculating chiller, it can also be heated and then be used to raise the temperature of the substrate.

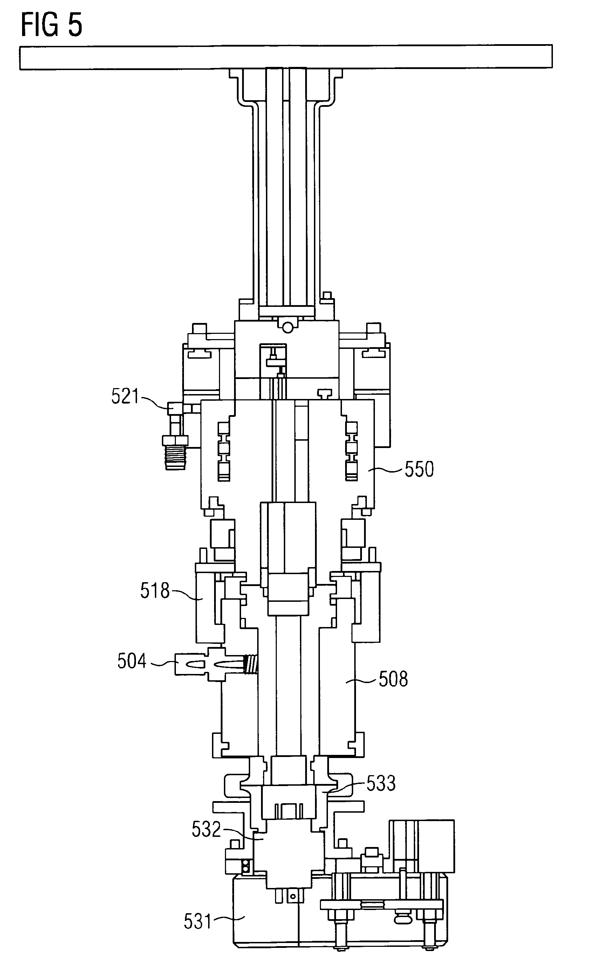

In the same and other embodiments the rotary fluid union is used to carry a cooling fluid to cool the sealing mechanisms lowering the chance that friction and heat will combine to degrade rotary seals. An embodiment showing this functionality is depicted in FIG. 5. The rotary fluid union **508** is located closer to the rotary seal housing **550** in this case. Channels for directing the cooling fluid may be designed into the substrate support shaft to allow circulation in the region of the rotary seals. One of the two stationary fluid connections **504** is shown. The differential pumping port is also shown and labeled **521.**

In some embodiments, rotary electrical feed-throughs are used for a variety of purposes which may include heating, cooling, substrate temperature measurement, substrate potential biasing, and electrostatically chucking the substrate to the substrate support member. This variety of applications puts constraints on the choice of rotary electrical feed-through incorporated into a substrate support assembly. Some of these applications may require high currents (e.g. resistive sample heating), high voltages (e.g. electrostatic chucking), and/or low noise (e.g. a thermocouple output). For example, in one disclosed embodiments, resistive heaters are placed in or near the substrate support pedestal to heat the substrate to temperatures between 100°C and 900°C. Alternate names for rotary electrical feed-throughs include rotary electrical couplings or unions.

The rotary electrical feed-through is shown in FIG. 5. The stationary electrical contacts **531** provide electrical connection to corresponding rotating electrical contacts **533.** Mechanisms of suitable rotary electrical conduction include metal brushes, metal bushings, ball-bearings, rolling rings, and liquid mercury. Sliding metal brushes can be used, each making contact with a separate ring of metal and conducting distinct electrical signals and/or providing distinct electrical supplies. Other types of electrical contact also supply multiple signals in a similar manner. In another embodiment, the rotary electrical contact is provided by a "rolling ring" wherein a conducting disk rotates inside a conducting tube with a larger inner diameter than the diameter of the disk. Essentially constant contact is made near a moving point of contact. Another embodiment provides a rotary electrical contact by rotating two solid conducting pieces through a confined Mercury bath. In this case the electrical power or signal is conducted through a liquid.

All the listed mechanisms can be engineered to supply the voltages and currents required for the listed applications. However, using a liquid mercury union reduces the nonuniformity of the electrical resistance which enables small thermocouple signals to be output from the processing system with less degradation. Minimizing the nonuniformity of the electrical resistance during rotation also reduces the chance of sparking which can shorten the useful lives of the components of the rotary electrical union. The placement of the rotary electrical union entirely on the atmospheric side of the rotary seals occurs in embodiments and eliminates the need for the rotary electrical union to be vacuum compatible in embodiments. The term feed-through when used to describe the rotary electrical union is not, therefore, restricted to describe a connection that can maintain a vacuum on one side and atmospheric pressure on the other.

Regardless of the connection mechanism or placement, more than one electrical connection can be made in a single rotary union. A four connection union could be used for heating the substrate with a resistive input and reading the temperature by monitoring a thermocouple. As long as the electrical specifications are met, it is desirable to have as many electrical connections as possible in order to retain as much flexibility as possible.

An electrical motor can be used to rotate the substrate assembly outside the processing chamber which causes the substrate pedestal and substrate (when present) to rotate inside the chamber. The motor can be attached to the shaft of the substrate assembly coaxially but can also be coupled with one or several gears, belts, chains or an equivalent linkage. It is easiest to transfer a substrate in and out of a chamber if the pedestal comes to rest at a known angular position. As a result of this consideration, the motor should have the ability to go to a specific angle after rotation (also referred to as having a homing capability). Some motors are available commercially which will automatically home at the conclusion of a period of rotation. The motor can be homed after each recipe or step within a recipe. In embodiments, the motor is a hollow shaft motor or a hollow gear motor (from e.g. Oriental motor or Sanyo Denki motor). A hollow gear motor establishes a high torque with a low profile and results in good angular control. Such a motor is shown integrated with the substrate support assemblies of FIG. 4 (**418**) and FIG. 5 (**518**). Software can be written to control when the motor rotates, its rotational velocity and the rate of acceleration.

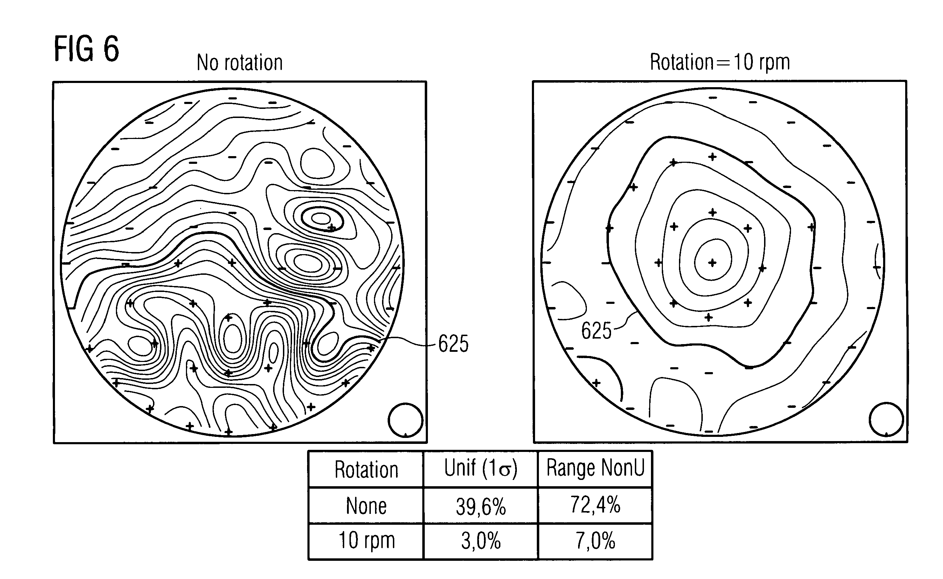

A representative result from the use of disclosed embodiment are shown in FIG. 6. Shown are 49-point circular substrate (i.e. wafer) maps showing deviations of the thickness of glass films about their mean value. These particular films are silicon oxide films grown with a process designed to fill narrow gaps (the Alectrona® process from Applied Materials). Two physically distinct paths were used to introduce supplies of oxidizing and organo-silane precursors, avoiding reaction until near or on the substrate surface. The oxidizing precursor was pre-processed by a remote plasma system to create oxygen radicals. The solid lines **625** represent the approximate locations where each oxide film has a mean thickness similar to the mean of all 49 points. Other lines of constant thickness are shown for thicker and thinner readings which were made near the plus and minus signs, respectively. The edge exclusion during these measurements was about 3 mm.

Without rotation (shown on the left of FIG. 6), the deposited film shows a high number of tightly spaced lines indicating rapid and large changes in film thickness. Introducing a very modest rotation of only 10 RPM provides a very different result (see the right side of FIG. 6). The number of equi-thickness lines is reduced and the separation has been increased. Many of the lines form basically circular patterns indicating the expected rotational symmetry of the deposition. A simple statistical comparison (shown below the two wafer maps in FIG. 6) shows a stark improvement as well. The percentages in the left column are statistical deviation about the mean of the measured values. The wafer map for the wafer which was not rotated during deposition has a standard deviation of 39.6% while the wafer map for the wafer which was rotated has a substantially lower measurement deviation of 3.0%.

Disclosed embodiments may be further refined by configuring the substrate support member to support a substrate so the center of the substrate is not on the axis of the substrate support shaft. At a time when the shaft is rotating, the substrate will rotate, but the center of the substrate will also rotate about the center of the shaft. In another disclosed embodiment, the axis of a substrate (a centered line perpendicular to the plane of a surface of the substrate) is tilted with respect to the axis of the substrate support shaft, resulting in a wobbly appearance as the substrate support assembly is rotated. Both these modifications reduce the symmetry of the process on the substrate which can homogenize the net effect of a processing step like the thickness of a deposited film. In an embodiment, the tilt of the substrate axis relative to the shaft axis is less than about 0.1°.

In embodiments, this tilt can be adjusted as part of a recipe step. It is desirable to have the substrate dropped of in a non-tilted position and put into a tilted position prior to deposition. Upon completion of processing, the substrate can be returned to the non-tilted position. This can be designed into a typical pedestal by using one of the rotary fluid unions to supply a driving pressure of gas into one or more captured plungers which raise one side of the substrate support member. Upon removal of the driving pressure, the pedestal returns to a non-tilted position.
Embodiments of substrate processing systems according to the invention are described herein. The systems may include a processing chamber, and a substrate support assembly at least partially disposed within the chamber. The substrate support assembly is rotatable by a motor yet still allows electricity, cooling fluids, gases and vacuum to be transferred from a non-rotating source outside the processing chamber to the rotatable substrate support assembly inside the processing chamber. Cooling fluids and electrical connections can be used to raise or lower the temperature of a substrate supported by the substrate support assembly. Electrical connections can also be used to electrostatically chuck the wafer to the support assembly. A rotary seal or seals (which may be low friction O-rings) are used to maintain a process pressure while still allowing substrate assembly rotation. Vacuum pumps can be connected to ports which are used to chuck the wafer. The pumps can also be used to differentially pump the region between a pair of rotary seals when two or more rotary seals are present.

### Exemplary Substrate Processing System

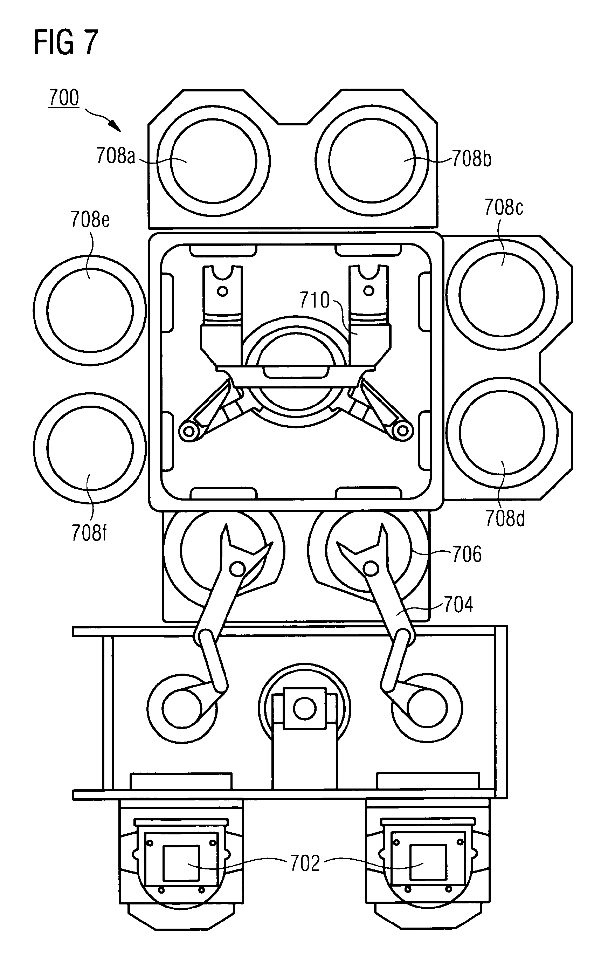

Embodiments of the deposition systems may be incorporated into larger fabrication systems for producing integrated circuit chips. Fig. 7 shows one such system **700** of deposition, baking and curing chambers according to disclosed embodiments. In the figure, a pair of FOUPs **702** supply substrate substrates (e.g., 300 mm diameter wafers) that are received by robotic arms **704** and placed into a low pressure holding area **706** before being placed into one of the wafer processing chambers **708a-f.** A second robotic arm **710** may be used to transport the substrate wafers from the holding area **706** to the processing chambers **708a-f** and back.

The processing chambers **708a-f** may include one or more system components for depositing, annealing, curing and/or etching a flowable dielectric film on the substrate wafer. In one configuration, two pairs of the processing chamber (e.g., **708c-d** and **708e-f**) may be used to deposit the flowable dielectric material on the substrate, and the third pair of processing chambers (e.g., **708a-b**) may be used to anneal the deposited dielectic. In another configuration, the same two pairs of processing chambers (e.g.,**708c-d** and **708e-f**) may be configured to both deposit and anneal a flowable dielectric film on the substrate, while the third pair of chambers (e.g., **708a-b**) may be used for UV or E-beam curing of the deposited film. In still another configuration, all three pairs of chambers (e.g., **708a-f**) may be configured to deposit an cure a flowable dielectric film on the substrate. In yet another configuration, two pairs of processing chambers (e.g., **708c-d** and **708e-f**) may be used for both deposition and UV or E-beam curing of the flowable dielectric, while a third pair of processing chambers (e.g. **708a-b**) may be used for annealing the dielectric film. It will be appreciated, that additional configurations of deposition, annealing and curing chambers for flowable dielectric films are contemplated by system **700.**

In addition, one or more of the process chambers **708a-f** may be configured as a wet treatment chamber. These process chambers include heating the flowable dielectric film in an atmosphere that include moisture. Thus, embodiments of system **700** may include wet treatment chambers **708a-b** and anneal processing chambers **708c-d** to perform both wet and dry anneals on the deposited dielectric film.

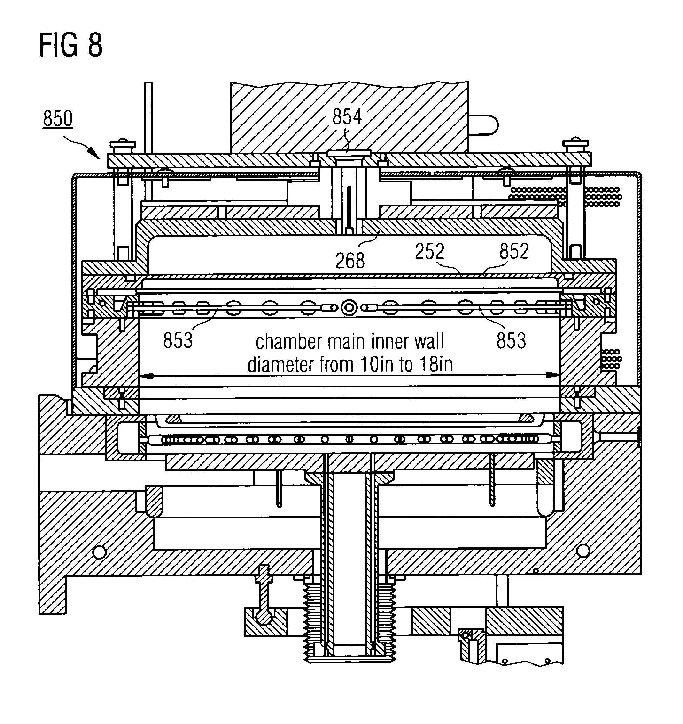

Fig. 8 shows another embodiment of an exemplary processing system **850** where a perforated plate **852** positioned above the side nozzles **853** distributes the precursors from a top inlet **854.** The perforated plate **852** distributes the precursors through a plurality of openings that traverse the thickness of the plate. The plate may replace or work in conjunction with the baffle **124** in FIG. 1. The plate **852** may have, for example from about 10 to 2000 openings (e.g., 200 openings). In the embodiment shown, the perforated plate may distribute oxidizing gases, such a atomic oxygen and/or other oxygen-containing gases like TMOS or OMCTS. In the illustrated configuration, the oxidizing gas is introduced into the deposition chamber above the silicon containing precursors, which are also introduced above the deposition substrate (from the side nozzles **853**).

Having described several embodiments, it will be recognized by those of skill in the art that various modifications, alternative constructions, and equivalents may be used without departing from the spirit of the disclosed embodiments. Additionally, a number of well known processes and elements have not been described in order to avoid unnecessarily obscuring the present invention. Accordingly, the above description should not be taken as limiting the scope of the invention.

Where a range of values is provided, it is understood that each intervening value, to the tenth of the unit of the lower limit unless the context clearly dictates otherwise, between the upper and lower limits of that range is also specifically disclosed. Each smaller range between any stated value or intervening value in a stated range and any other stated or intervening value in that stated range is encompassed. The upper and lower limits of these smaller ranges may independently be included or excluded in the range, and each range where either, neither or both limits are included in the smaller ranges is also encompassed within the invention, subject to any specifically excluded limit in the stated range. Where the stated range includes one or both of the limits, ranges excluding either or both of those included limits are also included.

As used herein and in the appended claims, the singular forms "a", "an", and "the" include plural referents unless the context clearly dictates otherwise. Thus, for example, reference to "a process" includes a plurality of such processes and reference to "the motor" includes reference to one or more motors and equivalents thereof known to those skilled in the art, and so forth.

Also, the words "comprise," "comprising," "include," "including," and "includes" when used in this specification and in the following claims are intended to specify the presence of stated features, integers, components, or steps, but they do not preclude the presence or addition of one or more other features, integers, components, steps, acts, or groups.

## Claims

1. A semiconductor processing system comprising:
a processing chamber (708a-f) having an interior capable of holding an internal chamber pressure which can be different from the external chamber pressure;
a pumping system coupled to said chamber and adapted to remove material from the processing chamber;
a substrate support assembly (340, 350) comprising:
a substrate support member (350) adapted to support a substrate inside the processing chamber;
a substrate support shaft (340) coupled to the substrate support member in a rotationally rigid manner, wherein the substrate support shaft can rotate relative to the processing chamber;
a motor (418; 518) coupled to the substrate support shaft and configured to rotate the substrate support assembly at a rotational speed between 1 RPM and 2000 RPM;
at least one rotary seal coupled between the substrate support shaft and the processing chamber, wherein the rotary seal allows the system to maintain an internal chamber pressure different from the external chamber pressure even when the substrate support assembly is rotating;
at least one rotary fluid coupling configured to conduct a fluid between at least one stationary channel and at least one rotatable channel within the processing chamber; and
a rotary electrical feed-through (531, 533) configured to allow electricity to pass between at least one stationary conductor outside the processing chamber and at least one rotatable conductor within the processing chamber.

2. The semiconductor processing system of claim 1, wherein the at least one rotary seal comprises at least two rotary seals and a differential pumping port is configured to provide a channel for removing gas from between the at least two rotary seals.

3. The semiconductor processing system of claim 1, wherein the rotary electrical feed-through is used to provide power to a heater near the substrate support member which provides a heating source to increase the temperature of the substrate support member and the substrate, or wherein the rotary electrical feed-through is used to provide a voltage to an electrostatic chucking mechanism of the substrate support member.

4. The semiconductor processing system of claim 1, wherein the rotational speed is between about 10 RPM and about 120 RPM..

5. The semiconductor processing system of claim 1, wherein the motor is configured to rotate the shaft in both clockwise and counterclockwise directions.

6. The semiconductor processing system of claim 1, wherein two of the at least one rotary fluid coupling are used to circulate a temperature controlled fluid through the rotating substrate support assembly.

7. The semiconductor processing system of claim 6, wherein the temperature controlled fluid passes through channels in the substrate support shaft to reduce the temperature of the substrate support member and the substrate, or wherein the temperature controlled fluid passes through channels in the substrate support shaft to cool the at least one rotary seal.

8. The semiconductor processing system of claim 1, wherein one of the at least one rotary fluid coupling is used to conduct vacuum up through the substrate support shaft to the substrate support member to chuck the substrate on the substrate support member.

9. The semiconductor processing system of claim 1, wherein the rotary electrical feed-through makes a rotary electrical connection utilizing at least one of the group consisting of liquid mercury, metal brushes, metal bushings, ball-bearings, and rolling rings.

10. The semiconductor processing system of claim 1, wherein the substrate is circular and the center of the substrate is on the axis of the substrate support shaft so the center of the substrate does not rotate significantly when the substrate rotates, or wherein the substrate is circular and the center of the substrate is not on the axis of the substrate support shaft so the center of the substrate rotates when the substrate support shaft rotates.

11. The semiconductor processing system of claim 1, wherein the substrate is circular and the axis of the substrate is tilted with respect to the axis of the substrate support shaft to create a wobble when the substrate support shaft rotates.

12. The semiconductor processing system of claim 11, wherein the tilt of the axis of the substrate is about 0.1° or less from the axis of the substrate support shaft.

13. The semiconductor processing system of claim 11, wherein the tilt of the axis of the substrate is adjustable during a film deposition.

14. The semiconductor processing system of claim 11, wherein the substrate is adjusted from a non-tilted to a tilted position during the film deposition..

15. The semiconductor processing system of claim 1, wherein the system comprises a lift mechanism coupled to the shaft for raising and lowering the substrate support member.
